Europäisches Patentamt

European Patent Office

Office européen des brevets

(19)

(11) **EP 0 857 700 B1**

(12) **FASCICULE DE BREVET EUROPEEN**

(45) Date de publication et mention
de la délivrance du brevet:
**23.04.2003 Bulletin 2003/17**

(51) Int Cl.[7]: **C03C 17/22**, C03C 17/34,
C03C 17/36, C23C 16/34

(21) Numéro de dépôt: **98400180.0**

(22) Date de dépôt: **29.01.1998**

(54) **Substrat transparent muni d'au moins une couche mince à base de nitrure ou d'oxynitrure de silicium et son procédé d'obtention**

Transparentes Substrat mit mindestens einer dünner Schicht aus Siliciumnitrid oder Oxynitrid und Verfahren zu dessen Herstellung

Transparent substrate with at least one thin silicon nitride or oxynitride based layer and process for obtaining the same

(84) Etats contractants désignés:
**AT BE CH DE ES FR GB IE IT LI LU NL PT**

(30) Priorité: **10.02.1997 FR 9701468**

(43) Date de publication de la demande:
**12.08.1998 Bulletin 1998/33**

(73) Titulaire: **SAINT-GOBAIN GLASS FRANCE**
**92400 Courbevoie (FR)**

(72) Inventeur: **Joret, Laurent**
**75011 Paris (FR)**

(74) Mandataire: **Renous Chan, Véronique et al**
**Saint-Gobain Recherche,**
**39, Quai Lucien Lefranc,**
**B.P. 135**
**93303 Aubervilliers Cedex (FR)**

(56) Documents cités:
**EP-A- 0 638 527       WO-A-89/10903**
**US-A- 5 116 665       US-A- 5 279 722**

- **YASUI K ET AL: "Growth of low stress SiN films containing carbon by magnetron plasma enhanced chemical vapor deposition" JOURNAL OF NON-CRYSTALLINE SOLIDS, JAN. 1991, NETHERLANDS, vol. 127, no. 1, ISSN 0022-3093, pages 1-7, XP002043906**

- **KANJI YASUI ET AL: "CHEMICAL VAPOR DEPOSITION OF LOW HYDROGEN CONTENT SILICON NITRIDE FILMS USING MICROWAVE-EXCITED HYDROGEN RADICALS" JAPANESE JOURNAL OF APPLIED PHYSICS, vol. 29, no. 5, 1 mai 1990, pages 918-922, XP000136931**
- **PATENT ABSTRACTS OF JAPAN vol. 016, no. 400 (C-0977), 25 août 1992 & JP 04 132639 A (NIPPON SHEET GLASS CO LTD), 6 mai 1992,**
- **PATENT ABSTRACTS OF JAPAN vol. 013, no. 524 (P-964), 22 novembre 1989 & JP 01 213600 A (KONICA CORP), 28 août 1989,**
- **PATENT ABSTRACTS OF JAPAN vol. 017, no. 674 (C-1140), 10 décembre 1993 & JP 05 221689 A (NIPPON SHEET GLASS CO LTD), 31 août 1993,**
- **PATENT ABSTRACTS OF JAPAN vol. 016, no. 548 (C-1005), 18 novembre 1992 & JP 04 209733 A (NIPPON SHEET GLASS CO LTD), 31 juillet 1992,**

Remarques:
Le dossier contient des informations techniques présentées postérieurement au dépôt de la demande et ne figurant pas dans le présent fascicule.

## Description

La présente invention concerne un substrat transparent que l'on munit d'au moins une couche mince. L'application principale de l'invention est la fabrication de vitrages dits fonctionnels utilisés soit dans les bâtiments, soit dans les véhicules, soit en tant qu'écran plasma de télévision. Une autre application envisageable est le traitement de surface de récipients du-type bouteilles en verre.

Dans le contexte de l'invention, il faut comprendre par vitrage fonctionnel un vitrage dont au moins un de ses substrats transparents constitutifs est recouvert d'un empilement de couches minces, afin de lui conférer des propriétés particulières, notamment thermiques, optiques, électriques ou mécaniques comme par exemple une propriété anti-rayure.

Il existe ainsi des couches minces appelées bas-émissives, notamment composées d'oxyde métallique dopé, par exemple d'oxyde d'étain dopé au fluor $(SnO_2:F)$ ou d'oxyde d'indium dopé à l'étain (ITO), et que l'on peut déposer sur du verre par des techniques de pyrolyse. Une fois revêtu d'une couche bas-émissive, le substrat monté en vitrage notamment dans un bâtiment permet de réduire l'émission dans l'infrarouge lointain vers l'extérieur de la pièce ou de l'habitacle à travers ledit vitrage. En diminuant ainsi les pertes énergétiques dues en partie à cette fuite de rayonnement, on améliore fortement le confort thermique, notamment en hiver.

Le substrat ainsi recouvert peut être monté en double-vitrage, la couche bas-émissive étant tournée du côté de la lame de gaz espaçant les deux substrats, par exemple disposée en face 3 (les faces d'un vitrage multiple sont conventionnellement numérotées en commençant par la face la plus extérieure par rapport à la pièce ou l'habitacle). Le double-vitrage ainsi constitué présente alors une isolation thermique renforcée, avec un coefficient d'échange thermique K faible tout en conservant le bénéfice des apports d'énergie solaire, avec un facteur solaire (soit le rapport entre l'énergie totale entrant dans le local et l'énergie solaire incidente) élevé. Le lecteur pourra se reporter, à ce sujet, notamment aux demandes de brevet EP-0544 577, FR-2704 543 et EP-0500 445.

Les couches bas-émissives sont également de bons conducteurs électriques, ce qui permet d'en équiper les vitrages pour l'automobile afin d'en faire des vitrages chauffants/dégivrants en prévoyant les amenées de courant adéquates, application décrite par exemple dans le brevet EP-0353 140.

Il existe également des couches minces filtrantes appelées sélectives ou anti-solaires qui, déposées sur des substrats montés en vitrage, permettent de réduire l'apport thermique du rayonnement solaire à travers le vitrage dans la pièce ou l'habitacle, par absorption/réflexion. Il peut s'agir, par exemple, de couches de nitrure (ou oxynitrure) de titane TiN, telles que celles obtenues par une technique de pyrolyse en phase gazeuse et décrites dans les demandes de brevet EP-0638 527 et EP-0650 938. Il peut aussi s'agir d'une couche réfléchissante en aluminium de faible épaisseur (inférieure ou égale à 30 nm), notamment obtenue par condensation de vapeur métallique, par CVD ou par la technique de dépôt décrite dans la demande de brevet internationale PCT/FR-96/00362 déposée le 07 mars 1996 au nom de SAINT-GOBAIN VITRAGE.

L'invention s'intéresse également aux techniques de dépôt de ces diverses couches, et plus particulièrement à celles ayant recours à une réaction de pyrolyse. Ces dernières consistent à projeter des «précurseurs», par exemple de nature organo-métallique, soit sous forme gazeuse, soit sous forme pulvérulente, soit liquides par eux-mêmes ou encore en solution dans un liquide, à la surface du substrat porté à haute température. Lesdits précurseurs, à son contact, s'y décomposent en laissant par exemple une couche de métal, d'oxyde, d'oxynitrure, ou de nitrure. L'avantage de la pyrolyse réside dans le fait qu'elle permet de réaliser le dépôt des couches directement sur le ruban de verre d'une ligne de fabrication de verre plat du type float, en continu, et également dans le fait que les couches pyrolysées présentent (en général) une forte adhérence au substrat.

Les couches bas-émissives ou filtrantes précédemment mentionnées font fréquemment partie d'un empilement de couches, et se trouvent au moins sur l'une de leurs faces, en contact avec une autre couche, en général un matériau diélectrique à rôle optique et/ou protecteur.

Ainsi, dans les demandes de brevet précitées EP-0544 577 et FR-2704 543, la couche bas-émissive, par exemple en $SnO_2:F$, est entourée de deux couches de diélectrique du type $SiO_2$, SiOC ou oxyde métallique, couches d'indice de réfraction et d'épaisseur sélectionnés afin d'ajuster l'aspect optique du substrat, notamment en reflexion, par exemple sa couleur.

Dans la demande de brevet EP-0500 445 également précitée, la couche bas-émissive en ITO, est surmontée d'une couche d'oxyde d'aluminium afin de la protéger de l'oxydation, et aussi, dans certaines conditions, de supprimer la nécessité de lui faire subir un recuit réducteur et /ou autoriser le bombage ou la trempe du substrat une fois revêtu sans détériorer ses propriétés.

La couche $TiO_2$ ou la double couche $TiO_2$/ SiOC qui surmonte la couche filtrante de TiN dans la demande de brevet précitée EP-0650 938 a également pour rôle de protéger le TiN de l'oxydation et d'améliorer sa durabilité en général.

Or, il est important de pouvoir s'assurer de l'intégrité des empilements de couches minces. Ainsi, il leur faut:

- une capacité à résister à des agressions de nature chimique. En effet, il arrive fréquemment que le substrat transparent, une fois revêtu de couches, soit stocké pendant une période assez longue avant d'être monté en vitrage. S'il n'est pas soigneusement conditionné de manière étanche, et donc coûteuse, les couches dont il est revêtu peuvent se trouver exposées directement à une atmosphère polluée ou soumises à un nettoyage par des détergents peu adaptés pour les dépoussiérer, même si les substrats sont ultérieurement assemblés en double-vitrage ou en vitrage feuilleté, avec les couches minces disposées en face 2 ou 3, donc protégées. Par ailleurs, outre ce problème de stockage, des empilements susceptibles de corrosion chimique sont un frein à une utilisation des substrats en tant que « vitrages monolithiques » ou à une disposition des couches en face 1 ou 4 dans le cas de vitrages multiples, c'est-à-dire des configurations où les couches sont à longueur d'année exposées à l'atmosphère ambiante.

- une aptitude à résister à des détériorations mécaniques. Par exemple, le substrat transparent, une fois revêtu de couches, peut être utilisé dans des configurations où il est facilement exposé à des détériorations du type rayure. De ce fait, d'une part le substrat n'offre plus visuellement un aspect esthétique «correct» puisque rayé partiellement et d'autre part, la durabilité à la fois de l'empilement et du substrat est très amoindrie, des sources de fragilisation mécanique pouvant, le cas échéant, être introduites.

On est donc en permanence à la recherche d'empilements de couches à durabilité chimique et/ou mécanique améliorées. Toutefois, ces améliorations ne doivent pas se faire au détriment des qualités optiques de l'ensemble constitué par le substrat et l'empilement de couches minces.

Comme précédemment évoqué, il existe déjà des surcouches en matériau diélectrique exerçant une certaine protection des couches sous-jacentes dans l'empilement. Pour rester intègre face à une corrosion chimique intense ou de longue durée et/ou pour protéger totalement les couches sous-jacentes éventuellement plus «fragiles», la demande de brevet EP-0712 815 décrit une couche mince à base d'oxyde comprenant du silicium et un troisième élément, par exemple sous la forme d'un halogène du type fluor F, qui facilite la formation d'une structure mixte en silicium et en aluminium.

Cette couche est particulièrement appropriée pour servir de dernière couche dans des empilements où la couche fonctionnelle est du type filtrante ou bas-émissive sur des vitrages, car elle peut remplir une fonction optique notamment une fonction d'optimisation de l'aspect en reflexion et garantir une certaine constance dans le temps de l'aspect des vitrages.

Cependant, elle n'est pas forcément apte à résister à des détériorations mécaniques telles que des rayures, car elle présente une dureté qui n'est pas extrêmement élevée.

Il est connu qu'un type de couche mince dure tout particulièrement adapté pour être durable et stable à l'abrasion mécanique et/ou à des agressions de nature chimique est une couche mince à base de nitrure de silicium, qui peut, le cas échéant, contenir une certaine proportion d'impuretés telles que l'oxygène et le carbone.

Il est ainsi connu un type de couche mince à base de nitrure de silicium déposée sur un substrat par une technique de pyrolyse en phase gazeuse à partir de deux précurseurs, le précurseur silicié étant un silane, le précurseur azoté étant soit minéral du type ammoniac, soit organique du type hydrazine notamment substituée par des méthyles.

Lorsque le dépôt est effectué à partir de précurseurs azotés du type ammoniac, les températures sont trop hautes (plus de 700°C) pour pouvoir être par exemple compatibles avec un dépôt en continu sur un ruban de verre silico-sodo-calcique dans l'enceinte d'un bain float car, à ces températures, ces verres standards n'ont pas encore attteint leur stabilité dimensionnelle.

Les précurseurs azotés du type hydrazine présentent quant à eux une certaine toxicité qui rend leur application industrielle délicate.

Il est également connu de déposer une couche mince à base de nitrure de silicium par la même technique que celle mentionnée ci-dessus notamment en utilisant non pas deux précurseurs, mais un seul qui est à la fois silicié et azoté du type $Si(NMe_2)_{4-n}H_n$. Les vitesses de dépôt qui peuvent être atteintes sont trop faibles pour pouvoir exploiter le procédé de dépôt à l'échelle industrielle. En outre, la synthèse de ce produit est relativement complexe et donc onéreuse, et on ne peut plus moduler les proportions respectives du(des) précurseur(s) azoté(s) et silicié(s).

De plus, les couches minces à base de nitrure de silicium connues présentent certains inconvénients :

- d'une part, elles ne sont pas nécessairement suffisamment dures et présentent une durabilité moindre, notamment lorsqu'elles sont déposées sous vide pour pouvoir, par exemple, conférer à un substrat muni de cette seule couche ou d'un empilement de couches minces comprenant cette couche une fonction anti-rayure.
- d'autre part, notamment lorsqu'elles sont déposées par pyrolyse, elles sont absorbantes aux longueurs d'onde du domaine visible, ce qui est pénalisant d'un point de vue optique.

YASUI K ET AL: "Growth of low stress SiN films containing carbon by magnetron plasma enhanced chemical vapor deposition" JOURNAL OF NON-CRYSTALLINE SOLIDS, JAN. 1991, NETHERLANDS, vol. 127, no. 1, ISSN 0022-3093, pages 1-7, XP002043906 et KANJI YASUI ET AL: "CHEMICAL VAPOR DEPOSITION OF LOW HYDROGEN CONTENT SILICON NITRIDE FILMS USING MICROWAVE-EXCITED HYDROGEN RADICALS" JAPANESE JOURNAL OF APPLIED PHYSICS, vol. 29, no. 5, 1 mai 1990, pages 918-922, XP000136931 décrivent des substrats en verre recouverts d'une couche mince à base de nitrure de silicium comprenant les éléments Si, N, O, C.

Le but de l'invention est alors de pallier aux inconvénients précités et donc de mettre au point une nouvelle couche mince à base de nitrure ou d'oxynitrure de silicium présentant une plus grande dureté tout en étant très peu absorbante, et susceptible de faire partie d'un empilement de couches minces, notamment afin d'y jouer un rôle de protection vis-à-vis de l'attaque chimique de l'empilement de couches minces dans lequel elle se trouve incorporée.

Un autre but de l'invention est de proposer un nouveau procédé de dépôt d'une couche mince à base de nitrure ou d'oxynitrure de silicium, notamment par une technique de pyrolyse en phase gazeuse, compatible avec un dépôt en continu sur un ruban de verre dans l'enceinte d'un bain float et qui permette d'atteindre des vitesses de dépôt élevées.

Pour ce faire, l'invention a tout d'abord pour objet un substrat transparent du type substrat verrier recouvert d'au moins une couche mince à base de nitrure ou d'oxynitrure de silicium. Selon l'invention, la couche mince comprend les éléments Si, O, N, C dans les pourcentages atomiques suivants:

- Si : de 30 à 60 %, notamment de 40 à 50 %,
- N : de 10 à 56 %, notamment de 20 à 56 %,
- O : de 1 à 40 %, notamment de 5 à 30 %,
- C : de 1 à 40 %, notamment de 5 à 30 %.

D'une manière surprenante, cette couche mince s'est révélée être à la fois très dure par rapport aux autres couches minces à base de nitrure de silicium connues, très transparente et donc peu ou pas absorbante aux longueurs d'onde du domaine visible: les taux élevés en Si et N montrent que l'on est en présence d'un matériau majoritairement en nitrure de silicium. En modulant les proportions entre les constituants minoritaires du type C, O, on parvient à ajuster finement les propriétés de la couche. Ainsi, en jouant sur les proportions relatives en carbone et en oxygène, on peut à la fois par exemple « régler » finement la densité et l'indice de réfraction de la couche mince de manière à lui conférer une dureté mécanique et des propriétés optiques tout à fait intéressantes et ciblées. Pour jouer sur les proportions relatives précitées, on peut éventuellement le faire avec un oxydant léger de type $CO_2$, par exemple pour des raisons optiques. Le carbone et l'azote ont en effet tendance à augmenter l'indice de réfraction, l'oxygène ayant plutôt l'effet inverse.

Par exemple, l'indice de réfraction de la couche est supérieur à 1,6, notamment compris entre 1,8 et 2,0, de préférence 1,85.

La couche peut comprendre d'autres éléments sous la forme d'un additif tel que le fluor, le phosphore ou le bore, de préférence dans un pourcentage atomique compris entre 0,1 et 5 %. La couche peut également être homogène ou à gradient de composition dans son épaisseur.

Avantageusement, la couche mince présente un coefficient d'absorption lumineuse $A_L$ inférieur à 2% pour 100 nanomètres d'épaisseur géométrique, qualité optique particulièrement mise en évidence lorsque le dépôt de ladite couche est effectué par une technique de pyrolyse en phase gazeuse, comme expliqué ci-après.

La couche mince fait avantageusement partie d'un empilement de couches minces, dont au moins une est une couche fonctionnelle à propriétés thermiques, notamment filtrantes, de protection solaire ou à bas-émissivité et/ou à propriétés électriques et/ou à propriétés optiques et/ou à propriétés photocatalytiques telles qu'une couche à fonction miroir, du type oxyde métallique dopé, nitrure/oxynitrure métallique ou métal du type aluminium ou silicium. Elle peut aussi faire partie d'un empilement de couches anti-reflets, en jouant le rôle de la couche à haut indice ou indice « intermédiaire ».

Comme oxyde métallique dopé ou nitrure/oxynitrure métallique, il peut être choisi l'oxyde d'étain dopé au fluor $SnO_2:F$, l'oxyde d'indium dopé à l'étain ITO, l'oxyde de zinc dopé à l'indium ZnO:In, au fluor ZnO:F, à l'aluminium ZnO:Al, à l'étain ZnO:Sn, l'oxyde mixte $Cd_2SnO_4$, le nitrure de titane TiN, le nitrure de zirconium ZrN.

Selon une caractéristique additionnelle, la couche peut être sous la couche fonctionnelle. Elle peut remplir alors notamment le rôle de couche barrière à la diffusion des ions notamment des alcalins, de l'oxygène à partir du substrat de type verrier, ou encore le rôle de couche de nucléation, et/ou avoir un rôle optique (ajustement de la couleur, effet anti-irisation, effet anti-reflets). Dans certaines applications du type écran-plasma, elle peut également remplir le rôle de couche barrière à la migration des ions $Ag^+$ à partir des couches fonctionnelles à base d'argent vers le substrat de type verrier.

Selon une autre caractéristique, la couche peut être disposée sur la couche fonctionnelle. Elle peut alors servir, notamment de couche protectrice de la couche fonctionnelle vis-à-vis de l'oxydation à haute température ou de la corrosion chimique, de couche de protection mécanique du type anti-rayure, de couche à rôle optique, de couche améliorant l'adhésion de la couche supérieure.

Selon une autre caractéristique, la couche mince est la seule couche recouvrant le substrat et remplit avantageusement une fonction anti-rayure. L'épaisseur géométrique de la couche peut être ajusté très librement dans une gamme très large de 5nm à 5μm, notamment entre 20 et 1000 nanomètres, une épaisseur assez conséquente d'au moins 250 nm étant par exemple privilégiée pour accentuer l'effet anti-rayure du substrat muni d'au moins ladite couche, une couche d'épaisseur plus faible étant généralement recherchée pour une autre fonctionnalité (nucléation, adhésion...).

L'invention a également pour objet le procédé d'obtention du substrat précédemment défini, procédé qui consiste à déposer la couche mince à base de nitrure de silicium par une technique de pyrolyse en phase gazeuse (appelée aussi « Chemical Vapor Deposition » en anglais ou CVD) qui utilise au moins deux précurseurs dont au moins un de silicium et au moins un d'azote. Selon le procédé de l'invention, au moins un précurseur d'azote est une amine.

Le choix d'un tel précurseur azoté est particulièrement avantageux : il est d'une réactivité adéquate dans la mesure où il permet d'effectuer le dépôt à des températures où le substrat verrier du type substrat standard silico-sodo-calcique a atteint parfaitement sa stabilité dimensionnelle, notamment dans le contexte d'une ligne de production de verre flotté.

De plus, les vitesses de dépôt atteintes sont suffisamment élevées pour pouvoir déposer des épaisseurs conséquentes dans l'enceinte de flottage.

Le précurseur silicié choisi peut être avantageusement un silane, du type hydrure et/ou alkyle de silicium, silazane.

L'amine peut être choisie parmi les amines primaires, secondaires ou tertiaires, notamment à radicaux alkyls ayant de 1 à 6 atomes de carbone chacun.

Ainsi, il peut s'agir de l'éthylamine $C_2H_5NH_2$, de la méthylamine $CH_3NH_2$, de la diméthylamine $(CH_3)_2NH$, de la butylamine $C_4H_9NH_2$, de la propylamine $C_3H_7NH_2$.

Le choix de l'amine appropriée pour une couche d'épaisseur géométrique et/ou d'indice de réfraction donnés résulte d'un compromis à trouver entre un certain nombre de paramètres tels que l'encombrement stérique, la réactivité...

De préférence, le rapport en nombre de moles de la quantité de précurseur d'azote sur la quantité de précurseur silicié est compris entre 5 et 30, avantageusement égal à 10.

Il est en effet important de contrôler un tel rapport pour éviter d'une part une incorporation insuffisante d'azote et d'autre part tout risque de nucléation en phase gazeuse et par là tout risque de formation de poudre. On limite ainsi les risques d'encrassement du dispositif et les baisses de rendement de production.

Selon une caractéristique supplémentaire, lorsqu'on désire incorporer un additif, on choisit un précurseur de l'additif indépendant du précurseur silicié et de l'amine. Il peut par exemple s'agir d'un gaz fluoré du type $CF_4$ lorsque l'additif désiré est du fluor F ou d'un gaz organique porteur de phosphate du type PO$(OCH_3)_3$ ou un gaz du type triéthylphosphite, triméthylphosphite, triméthylborite, $PF_5$, $PCl_3$, $PBr_3$, $PCl_5$ lorsque l'additif désiré est du phosphore P ou du bore B. Ces additifs permettent avantageusement d'augmenter généralement la vitesse de dépôt.

La température de dépôt est en adéquation avec le choix des précurseurs, notamment l'amine. Elle est comprise entre 550 et 760°C. Elle peut être comprise de préférence entre 600 et 700°C: c'est-à-dire entre la température où le verre notamment silico-sodo-calcique est dimensionnellement stable et la température qu'il a à sa sortie de l'enceinte du float.

Avantageusement, dans la variante où la composition verrière du substrat est adaptée à une application électronique, elle est comprise entre 660°C et 760°C.

Selon cette variante, une composition avantageuse peut être celle décrite dans la demande WO-96/11887. Celle-ci, exprimée en pourcentages pondéraux, est du type:

| | |
|---|---|
| $SiO_2$ | 45 - 68 % |
| $Al_2O_3$ | 0 - 20 % |
| $ZrO_2$ | 0 - 20 % |
| $B_2O_3$ | 0 - 20 % |
| $Na_2O$ | 2 - 12 % |
| $K_2O$ | 3,5 - 9 % |
| CaO | 1 - 13 % |
| MgO | 0 - 8 % |

avec :

- $SiO_2 + Al_2O_3 + ZrO_2 \leq 70\%$
- $Al_2O_3 + ZrO_2 \geq 2\ \%$
- $Na_2O + K_2O \geq 8\ \%$

et éventuellement du BaO et/ou du SrO dans des proportions suivantes :

$$11\% \leq MgO + CaO + BaO + SrO \leq 30\%$$

avec une température inférieure de recuisson d'au moins 530°C et un coefficient $\alpha$ de 80 à 95.10$^{-7}$°C$^{-1}$.

Une autre composition avantageuse, tirée de la demande FR97/00498 est, toujours en pourcentages pondéraux, du type :

| | |
|---|---|
| $SiO_2$ | 55 - 65 %, de préférence 55-60 % |
| $Al_2O_3$ | 0 - 5% |
| $ZrO_2$ | 5 - 10% |
| $B_2O_3$ | 0 - 3% |
| $Na_2O$ | 2 - 6% |
| $K_2O$ | 5 - 9% |
| MgO | 0 - 6 %, de préférence 1-6 % |
| CaO | 3 - 11 %, de préférence 7-11 % |
| SrO | 4 - 12 % |
| BaO | 0 - 2 % |

avec :

- Na$_2$O + K$_2$O ≥ 10 %
- MgO + CaO + SrO + BaO > 11 %, de préférence > 15%

et une température inférieure de recuisson d'au moins 600°C. (Une autre variante consiste, en gardant les proportions des autres constituants inchangés, à choisir un taux d'Al$_2$O$_3$ de 5 à 10% et un taux de ZrO$_2$ de 0 à 5%).

On rappelle que la température dite inférieure de recuisson (« Strain point ») est la température que présente un verre lorsqu'il atteint une viscosité η égale à 10$^{14.5}$ poises.

Il est ainsi préférable d'effectuer le dépôt de la couche à atmosphère essentiellement inerte ou réductrice, par exemple en mélange N$_2$/H$_2$ sans ou quasiment sans oxygène en continu sur un ruban de verre float, dans l'enceinte de flottage et/ou dans un caisson de contrôle de l'atmosphère inerte, sans oxygène, pour le déposer plus en aval de la ligne float, à des températures éventuellement un peu plus basses.

L'invention permet ainsi la fabrication de vitrages de contrôle solaire filtrants, avec des empilements du type:

- verre / TiN et/ou ZrN / couche selon l'invention / SiOC et/ou SiO$_2$, ladite couche selon l'invention permettant d'avoir une interface beaucoup plus solide entre la couche TiN et/ou la couche ZrN d'une part, et la couche SiOC et/ou la couche SiO$_2$, d'autre part. Elle permet également d'avoir une protection efficace du TiN et/ou du ZrN contre l'éventuel risque d'oxydation superficielle soit sur ligne industrielle après le dépôt de la couche de SiOC et/ou de SiO$_2$, soit hors ligne industrielle par exemple lorsque le substrat muni de l'empilement de couches, une fois découpé, subit des traitements thermiques du type bombage/trempe ou recuit. Avantageusement, la couche présente une épaisseur géométrique comprise entre 10 et 50 nanomètres, la couche mince selon l'invention présente une épaisseur géométrique comprise entre 5 et 20 nanomètres, et la surcouche en SiOC et/ou SiO$_2$ une épaisseur géométrique comprise entre 30 et 100 nanomètres.
- ou encore du type:
    verre / Al / couche mince selon l'invention,

la couche réfléchissante en aluminium étant soit de faible épaisseur (inférieure ou égale à 30 nm) soit de plus forte épaisseur lorsque la fonction miroir est recherchée, telle que celle décrite dans la demande de brevet internationale précitée PCT/FR-96/00362, la couche mince selon l'invention ayant à la fois un rôle d'agent protecteur vis-à-vis de l'oxydation et une fonction anti-rayure.

L'invention permet également de réaliser des vitrages dont la fonctionnalité essentielle est d'être anti-rayure, c'est-à-dire des vitrages tels que des dalles de sol, du mobilier en verre où le substrat verrier est uniquement revêtu de la couche mince à base de Si$_3$N$_4$ selon l'invention éventuellement associée à une couche anti-irisation.

On protège ainsi avantageusement le verre de toute dégradation.La couche mince selon l'invention peut également être associée à des couches bas-émissives avec des empilements du type:

    verre / SiOC / SnO$_2$:F ou ITO / couche mince selon l'invention.

Dans ces empilements, la sous-couche en SiOC peut bien évidemment être remplacée par d'autres oxydes métalliques, tels que ceux décrits dans la demande de brevet EP-0677 493.

La couche mince selon l'invention permet de même de fabriquer tout type de vitrages fonctionnels munis d'un empilement de couches minces qui sont de grande durabilité et qui sont aptes à être trempés et/ou bombés lorsque le substrat utilisé est un substrat verrier.

L'invention permet en outre de réaliser des vitrages pour lesquels une fonction anti-salissure est recherchée, avec des empilements du type :

    Verre /couche mince selon l'invention/TiO$_2$

Dans ces empilements, la couche mince selon l'invention a essentiellement pour rôle de servir de couche barrière aux alcalins migrant du verre vers la couche à base d'oxyde de titane TiO$_2$, l'effet photocatalytique de ce dernier étant ainsi accru. De plus, si l'épaisseur de la couche selon l'invention est adaptée de manière à ce qu'elle soit en interaction interférentielle, elle a également pour rôle d'être une couche anti-irisation.

L'oxyde de titane TiO$_2$ peut être sous la forme de particules majoritairement cristallisées de type anatase, tel que décrit dans la demande de brevet WO 97/10188.

Mais, il peut être également sous la forme d'un film au moins en partie cristallisé, tel que celui décrit dans la demande de brevet WO 97/10186.

L'invention permet enfin la fabrication d'écrans émissifs du type écrans plats tels que les écrans plasma. La couche mince selon l'invention peut jouer alors des rôles différents en fonction de la nature de la composition chimique du substrat sur lequel elle est déposée, et/ou de la destination (face avant ou arrière) de ce même substrat dans l'écran et donc, de la nature des couches fonctionnelles qui la surmontent, telles que les électrodes, les luminophores (photophores), éléments indispensables au fonctionnement de l'écran.

Ainsi, dans le cas où le substrat verrier est du type « alkali-bloqué », c'est-à-dire de composition substantiellement dénuée d'espèces diffusantes du type alcalins, la couche mince selon l'invention remplit très efficacement le rôle essentiel de couche barrière à la migration d'espèces diffusantes des revêtements supérieurs vers le substrat, en particulier de l'électrode à base d'argent.

De même, dans le cas où la composition du substrat verrier comporte des alcalins, elle joue également le rôle de couche barrière à leur migration.

L'invention s'applique également au traitement de surface de récipients du type bouteille en verre ou flacons, la couche dure selon l'invention renforçant lesdits récipients par exemple vis-à-vis des manipulations susceptibles de les détériorer et ceci quelle que soit l'inhomogénéité relative d'épaisseur de ladite couche constatée. Le dépôt de la couche dure selon l'invention peut ainsi s'effectuer sur la paroi externe des récipients en la renforçant mécaniquement notamment contre des chocs mais aussi sur la paroi interne des récipients afin, par exemple, d'empêcher le relargage d'éléments à partir du substrat.

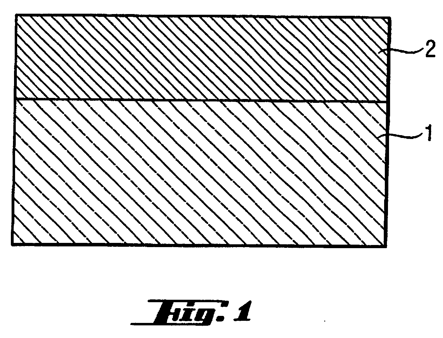

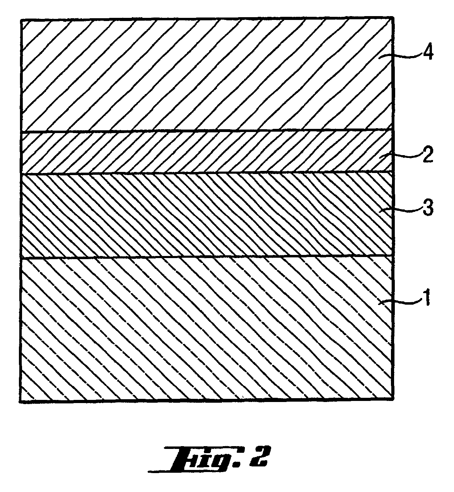

D'autres détails et caractéristiques avantageuses ressortent ci-après de la description d'exemples de réalisation non limitatifs à l'aide de la figure 1 et 2 annexées. Par souci de clarté, ces figures ne respectent pas les proportions concernant les épaisseurs relatives des différents matériaux.

Dans tous les exemples suivants, le dépôt de toutes les couches minces est effectué dans l'enceinte de flottage.

## EXEMPLE 1:

La figure 1 représente un substrat 1 de verre silico-sodo-calcique clair de 3 millimètres d'épaisseur, par exemple celui commercialisé sous marque PLANILUX par la société SAINT-GOBAIN VITRAGE, recouvert de la couche mince à base de nitrure de silicium 2 mise au point par l'invention.

La couche mince à base de nitrure de silicium 2 est obtenue par une technique de pyrolyse en phase gazeuse à partir de silane $SiH_4$, qui est le précurseur silicié, et de l'éthylamine $C_2H_5NH_2$, qui est le précurseur azoté.

Les débits de précurseurs sont choisis tels que le rapport en volume de la quantité d'éthylamine sur la quantité de silane est égal à environ 10. Ce paramètre est avantageux en ce sens qu'il optimise l'apport de chacun des constituants de la couche. En effet, il a été observé qu'il ne doit pas être:

- trop élevé sinon il peut y avoir un risque de nucléation en phase gazeuse et donc un risque de formation de poudre.
- trop faible sinon il peut y avoir une incorporation insuffisante d'azote dans la couche.

Une plage de rapports de 5 à 30 s'avère tout à fait satisfaisante, lorsqu'on veut déposer une couche de 50 à 300 nm d'épaisseur à partir d'un silane et de l'éthylamine.

Le dépôt a été effectué sur le substrat 1 porté à une température comprise entre 600 et 650°C, à pression atmosphérique.

Dans ces conditions, la vitesse de croissance de la couche 2 selon l'invention a atteint 60nm par minute.

La couche 2 obtenue telle que représentée à la figure 1 a une épaisseur d'environ 350 nanomètres et un indice de réfraction de l'ordre de 1,85.

Une analyse par microsonde indique que la couche 2 comporte, en pourcentages atomiques, 32,7 % de silicium, 30,6% d'azote, 21,1% de carbone et 15,6% d'oxygène.

La technique de dépôt selon l'invention permet de moduler les quantités des différents éléments incorporés, notamment celle du carbone en jouant sur différents paramètres tels que la température à laquelle on effectue le dépôt, l'utilisation d'une autre amine que l'éthylamine ou d'un mélange d'amines ou de l'ammoniac ajouté à l'éthylamine comme précurseur d'azote.

Les différentes amines qui ont une réactivité adéquate sont les suivantes: la méthylamine $CH_3NH_2$, de la diméthylamine $(CH_3)_2NH$, de la butylamine $C_4H_9NH_2$ et la propylamine $C_3H_7NH_2$. Les températures satisfaisantes au dépôt de la couche 2 selon l'invention sont comprises dans une gamme de 550 à 700°C.

Les caractéristiques spectrophotométriques d'une telle couche sont regroupées dans le tableau ci-dessous, dans lequel $T_L$, $R_L$, $A_L$ représentent respectivement les valeurs de la transmission lumineuse, de la réflexion lumineuse et de l'absorption lumineuse en pourcentage:

|  | $T_L$ | $R_L$ | $A_L$ |
|---|---|---|---|
| Couche 2 | 84 | 13 | 3 |

ces valeurs étant mesurées à partir de l'illuminant $D_{65}$, à incidence quasi-normale.

On constate que la couche selon l'invention présente une absorption lumineuse très faible et qu'elle est exempte de flou. (On rappelle que le flou est le rapport de la transmission diffuse sur la transmission lumineuse à une longueur d'onde égale à 550 nm).

Sur le substrat 1 recouvert de la seule couche 2 selon l'invention a été effectué un test qui permet d'évaluer la résistance mécanique de ladite couche. Ce test est effectué à l'aide de meules faites de poudre abrasive noyée dans un élastomère. La machine est fabriquée par la société TABER INSTRUMENT CORPORATION Il s'agit du modèle 174 «standard Abrasion Tester », les meules sont de type CSIOF chargées de 500 grammes. On soumet le substrat 1 recouvert localement à 50 rotations, puis on réalise à l'aide d'un microscope optique un comptage des rayures sur quatre carrés de côté égal à 1 inch. soit 2,54 cm. Après avoir réalisé ce comptage, on calcule la moyenne R du nombre de rayures par carré. Enfin, on calcule le « score Taber » $T_S$ suivant la formule :

$$T_S = -0,18 \ R + 10$$

Pour une couche 2 selon l'invention de 300 nanomètres d'épaisseur géométrique, ce « score » est égal à 9,3. Cette valeur dénote une détérioration peu importante et révèle donc une très bonne résistance de la couche selon l'invention à la rayure.

A titre d'exemple comparatif, on peut noter qu'une couche d'oxyde d'étain dopé au fluor $SnO_2$:F de 340 nanomètres d'épaisseur géométrique, connue comme étant la couche « la plus dure » déposée par une technique de pyrolyse en phase gazeuse, présente, suite au test un « score Taber » $T_S$ égal à 9,1.

On voit donc bien que la couche à base de nitrure de silicium selon l'invention est une couche qui, intrinsèquement, présente une très bonne résistance à l'abrasion mécanique et est d'un point de vue optique très satisfaisante puisque très transparente et très peu absorbante aux longueurs d'onde du domaine visible.

### EXEMPLE 2:

La figure 2 représente un vitrage de type protection solaire comportant un empilement de couches minces dans lequel a été incorporée la couche 2 selon l'invention.

Le substrat 1 de verre silico-sodo-calcique clair de 6 millimètres d'épaisseur est recouvert de trois couches successivement:

- une première couche 3 en TiN d'épaisseur 23 nm obtenue par pyrolyse en phase gazeuse à partir d'un tétrachlorure de titane $TiCl_4$ et de la méthylamine $CH_3NH_2$ tel que décrit dans la demande de brevet EP-0638 527.
- une deuxième couche 2 selon l'invention d'épaisseur environ égale à 10 nanomètres et d'indice de réfraction égal à 1,85, déposée dans les mêmes conditions que l'exemple 1.
- une troisième couche 4 en oxycarbure de silicium SiOC d'épaisseur 65 nm. d'indice de réfraction égale à 1,65, obtenue également par pyrolyse en phase gazeuse à partir de silane et d'éthylène comme décrit dans la demande de brevet EP-0518 755, la couche essentiellement sous forme siliciée s'oxydant à la sortie du float, et plus particulièrement dans l'étenderie.

On a donc un empilement de type:
　　　verre / TiN / $Si_3N_4$ / SiOC.

### EXEMPLE 3:

On a réalisé cet exemple comparatif utilisant un empilement:
　　　verre / TiN / SiOC.
où les deux couches en TiN et SiOC ont les mêmes caractéristiques que celles définies précédemment et sont obtenues dans les mêmes conditions de dépôt.

On constate que la couche 2 selon l'invention, même d'une faible épaisseur, crée une interface très solide entre la première couche 3 de TiN et la surcouche 4 de SiOC.

De plus, la couche 2 selon l'invention protège efficacement le TiN de l'éventuel risque d'oxydation superficielle sur la ligne industrielle après dépôt de la surcouche 4 de SiOC. Le cas échéant, elle isole le TiN lorsque le substrat une fois découpé, subit des traitements thermiques ultérieurs du type bombage/trempe ou recuit.

De même après avoir mesuré les valeurs spectrophotométriques, notamment la transmission lumineuse $T_L$ pour chacun des deux empilements des exemples 2 et 3, ainsi que le facteur solaire $F_S$, on constate que la sélectivité correspondant à la différence $T_L$-$F_S$ est bien meilleure dans le cas du « tri-couche » de l'exemple 2 avec la couche 2 selon l'invention intercalée entre les deux couches en TiN et SiOC puisque sa valeur est de 10 %. Dans le cas du « bi-couche » de l'exemple 3 elle est inférieure à 7 %.

Il est à noter enfin que si dans les deux configurations précédentes, la couche à base de nitrure de silicium selon l'invention est homogène dans son épaisseur, on peut aussi bien prévoir une certaine inhomogénéité en composition dans son épaisseur, notamment afin de moduler l'indice de réfraction et permettre une compatibilité optique et/ou chimique optimale avec la couche au dessus et/ou en dessous tel que par exemple une couche enrichie en $Si_3N_4$ du côté du TiN et une couche enrichie en SiON du côté de SiOC dans un vitrage de protection solaire utilisant les mêmes couches que dans l'exemple 2. Cette couche à « gradient » peut être obtenue à partir de la même technique de dépôt par pyrolyse en phase gazeuse mais en utilisant une buse apte à créer des gradients chimiques telle que celle décrite dans la demande de brevet FR-2 736 632.

En conclusion, l'invention a mis au point une nouvelle couche à base de nitrure de silicium, particulièrement apte à résister à l'abrasion mécanique et très satisfaisante d'un point de vue optique puisque très peu absorbante, ce qui n'est pas le cas des couches à base de $Si_3N_4$ connues.

Très avantageusement, la couche selon l'invention peut se déposer par pyrolyse en phase gazeuse à des vitesses de dépôt élevées à l'aide d'un précurseur azoté que l'on peut utiliser industriellement sans surcoût prohibitif.

Le précurseur azoté utilisé est en outre d'une réactivité adéquate car il permet d'atteindre des températures de dépôt à partir desquelles il est possible sans difficulté majeure de réaliser des empilements tri-couche en ligne sur le ruban de verre float, par exemple afin de réaliser un vitrage anti-solaire avec la couche fonctionnelle en TiN et la dernière couche en SiOC, la couche selon l'invention étant avantageusement incorporée à l'empilement « bi-couche » classique pour donner une interface plus solide et pour isoler la couche fonctionnelle de l'oxydation après le dépôt de la surcouche en SiOC et ceci, sans perturber la production sur ligne industrielle, ou encore lors de traitements thermiques du substrat hors ligne industrielle.

**Revendications**

1. Substrat transparent (1) du type substrat verrier recouvert d'au moins une couche mince (2) à base de nitrure ou d'oxynitrure de silicium, **caractérisé en ce que** ladite couche mince (2) est déposée à une température comprise entre 550 et 760°C, préférentiellement entre 660°C et 760°C et comprend les éléments Si, O, N, C dans les pourcentages atomiques suivants:

   - Si: de 30 à 60 %, notamment de 40 à 50 %,
   - N : de 10 à 56 %, notamment de 20 à 56 %,
   - O : de 1 à 40 %, notamment de 5 à 30 %,
   - C : de 1 à 40 %, notamment de 5 à 30 %.

2. Substrat selon la revendication 1, **caractérisé en ce que** ladite couche mince comprend au moins un additif, notamment sous la forme d'un halogène, de préférence du fluor F et/ou sous la forme de phosphore P ou de bore B, de préférence dans un pourcentage atomique compris entre 0,1 et 5 %.

3. Substrat selon l'une des revendications précédentes, **caractérisé en ce que** ladite couche mince est homogène ou à gradient de composition dans son épaisseur.

4. Substrat selon l'une des revendications précédentes, **caractérisé en ce que** ladite couche mince présente un coefficient d'absorption lumineuse $A_L$ inférieur à 2% pour 100 nanomètres d'épaisseur géométrique.

5. Substrat selon l'une des revendications précédentes, **caractérisé en ce que** ladite couche mince présente une épaisseur géométrique comprise entre 5nm et 5μm, notamment entre 20 et 1000 nanomètres.

6. Substrat selon l'une des revendications précédentes, **caractérisé en ce que** ladite couche mince présente un indice de réfraction supérieur à 1,6, notamment compris entre 1,8 et 2,0, de préférence 1,85.

7. Substrat selon l'une des revendications précédentes, **caractérisé en ce que** ladite couche mince fait partie d'un empilement de couches minces, dont au moins une est une couche fonctionnelle à propriétés thermiques, notamment filtrantes de protection solaire ou à bas-émissivité et/ou à propriétés électriques et/ou à propriétés optiques et/ou à propriétés photocatalytiques telles qu'une couche à fonction miroir, du type oxyde métallique dopé, nitrure/oxynitrure métallique ou métal du type aluminium ou silicium, ou fait partie d'un empilement de couches anti-reflets.

8. Substrat selon la revendication 7, **caractérisé en ce que** ladite couche mince est sous la couche fonctionnelle, notamment comme couche barrière à la diffusion aux ions notamment des alcalins, de l'oxygène à partir dudit substrat du type substrat verrier, couche barrière à la migration des ions de la couche fonctionnelle vers le substrat du type substrat verrier destiné à la fabrication d'écran plasma, couche de nucléation, couche à rôle optique.

9. Substrat selon la revendication 7, **caractérisé en ce que** ladite couche mince est sur la couche fonctionnelle, notamment comme couche de protection de la couche fonctionnelle vis-à-vis de l'oxydation à haute température ou de la corrosion chimique, couche de protection mécanique du type anti-rayure, couche à rôle optique, couche améliorant l'adhésion de la couche supérieure.

10. Substrat selon l'une des revendications 7 à 9, **caractérisé en ce que** la couche fonctionnelle est en oxyde d'étain dopé au fluor $SnO_2$:F, en oxyde d'indium dopé à l'étain ITO, en oxyde de zinc dopé à l'indium ZnO:In, au fluor ZnO:F, à l'aluminium ZnO:Al ou à l'étain ZnO:Sn, l'oxyde mixte $Cd_2 SnO_4$ ou en nitrure ou oxynitrure de titane TiN ou en nitrure de zirconium ZrN.

11. Substrat selon l'une des revendications 1 à 6, **caractérisé en ce que** ladite couche mince (2) est la seule couche recouvrant le substrat ou est associée à une couche anti-irisation et remplit une fonction anti-rayure.

12. Substrat selon la revendication 11, **caractérisé en ce que** ladite couche mince (2) présente une épaisseur géométrique d'au moins 250 nanomètres.

13. Substrat selon l'une des revendications 1 à 10, **caractérisé en ce que** ladite couche mince fait partie d'un empilement du type verre / TiN et/ou ZrN / couche mince (2) / SiOC et/ou $SiO_2$ et remplit notamment une fonction d'interface solide entre TiN et/ou ZrN et SiOC et/ou $SiO_2$ et une fonction anti-oxydante après le dépôt de la surcouche en SiOC et/ou en $SiO_2$ sur et/ou hors ligne industrielle.

14. Substrat selon la revendication 13, **caractérisé en ce que** ladite couche en TiN présente une épaisseur géométrique comprise entre 10 et 50 nanomètres, ladite couche mince (2) présente une épaisseur géométrique comprise entre 5 et 20 nanomètres, ladite surcouche en SiOC et/ou SiO₂ présente une épaisseur géométrique comprise entre 30 et 100 nanomètres et **en ce que** ledit empilement présente une sélectivité d'au moins 7 %.

**15.** Procédé de dépôt de la couche mince (2) selon l'une des revendications précédentes effectué par une technique de pyrolyse en phase gazeuse à partir d'au moins deux précurseurs dont au moins un précurseur de silicium et au moins un précurseur d'azote **caractérisé en ce qu'** au moins un précurseur d'azote est sous la forme d'une amine et **en ce que** la température de dépôt est choisie entre 550 et 760°C, avantageusement entre 660°C et 760°C.

**16.** Procédé selon la revendication 15, **caractérisé en ce que** le précurseur de silicium est un silane, du type hydrure et/ou alkyle de silicium, silazane.

**17.** Procédé selon la revendication 15 ou 16, **caractérisé en ce que** l'amine est une amine primaire, secondaire ou tertiaire, notamment à radicaux alkyls ayant de 1 à 6 atomes de carbone chacun.

**18.** Procédé selon la revendication 17, **caractérisé en ce que** l'amine est de l'éthylamine $C_2H_5NH_2$, de la méthylamine $CH_3NH_2$, de la diméthylamine $(CH_3)_2NH$, de la butylamine $C_4H_9NH_2$, de la propylamine $C_3H_7NH_2$.

**19.** Procédé selon l'une des revendications 15 à 18, **caractérisé en ce que** le rapport en nombre de moles de la quantité de précurseur(s) d'azote sur la quantité de précurseur(s) de silicium est compris entre 5 et 30, de préférence 10.

**20.** Procédé selon l'une des revendications 15 à 19, **caractérisé en ce que** le précurseur de l'additif est indépendant des précurseurs de silicium et d'azote, et est notamment un gaz fluoré du type $CF_4$ lorsque l'additif est du fluor F et un gaz organique porteur de phosphate du type $PO(OCH_3)_3$ ou un gaz du type triéthylphosphite, triméthylphosphite, triméthylborite, $PCl_3$, $PF_5$, $PBr_3$, $PCl_5$ lorsque l'additif est du phosphore P ou du bore B.

**21.** Procédé selon l'une des revendications 15 à 20, **caractérisé en ce que** l'on effectue le dépôt de ladite couche mince, dans une atmosphère essentiellement inerte ou hydrogénée, sans oxygène, en continu sur un ruban de verre float, dans l'enceinte de flottage et/ou dans un caisson de contrôle de l'atmosphère inerte ou réductrice.

**22.** Application du substrat selon l'une des revendications 1 à 12 ou du procédé selon l'une des revendications 15 à 21, à la fabrication de vitrages munis de couches minces, de protection solaire du type filtrants ou bas-émissifs et/ou anti-rayure et/ou à fonction miroir ou anti-reflets et/ou à fonction anti-salissure, de faces « avant ou arrière » d'écrans émissifs du type écrans plats tels que les écrans plasma.

**23.** Application selon la revendication 22, à la fabrication de vitrages munis de couches minces trempables/bombables et/ou de grande durabilité.

**24.** Application selon la revendication 23, aux vitrages monolithique, feuilletés, multiples dans lesquels le (s) substrat(s) est(sont) clair(s) ou teinté(s) dans la masse.

**25.** Application du produit selon l'une des revendications 1 à 11 ou du procédé selon l'une des revendications 15 à 21, au traitement de surface interne et/ou externe de récipients du type bouteilles en verre ou flacons.

**Claims**

**1.** Transparent substrate (1) of the glass substrate type covered with at least one thin film (2) based on silicon nitride or oxynitride, **characterised in that** the said thin film (2) is deposited at a temperature of between 550º and 760ºC, preferentially between 660ºC and 760ºC, and comprises the elements Si, O, N and C in the following atomic percentages:

- Si: 30% to 60%, in particular 40% to 50%,

- N: 10% to 56%, in particular 20% to 56%,

- O: 1% to 40%, in particular 5% to 30%,

- C: 1% to 40%, in particular 5% to 30%.

**2.** Substrate according to Claim 1, **characterised in that** the said thin film comprises at least one additive, in particular in the form of a halogen, preferably fluorine F, and/or in the form of phosphorus P or boron B, preferably in an atomic percentage of between 0.1% and 5%.

**3.** Substrate according to one of the preceding claims, **characterised in that** the said thin film is homogeneous or has a composition gradient in its thickness.

**4.** Substrate according to one of the preceding claims, **characterised in that** the said thin film has a light absorption coefficient $A_L$ of less than 2% for 100 nanometres of geometric thickness.

5. Substrate according to one of the preceding claims, **characterised in that** the said thin film has a geometric thickness of between 5 nm and 5 $\mu$m, in particular between 20 and 1000 nanometres.

6. Substrate according to one of the preceding claims, **characterised in that** the said thin film has a refractive index greater than 1.6, in particular between 1.8 and 2.0, preferably 1.85.

7. Substrate according to one of the preceding claims, **characterised in that** the said thin film forms part of a stack of thin films, at least one of which is a functional film with thermal properties, in particular solar protection or low emissivity filtration properties and/or electrical properties and/or optical properties and/or photocatalytic properties, such as a film with a mirror function, of the doped metallic oxide or metallic nitride/oxynitride type or a metal of the aluminium or silicon type, or forms part of a stack of nonreflective films.

8. Substrate according to Claim 7, **characterised in that** the said thin film is under the functional film, notably as a film which is a barrier to the diffusion of ions, in particular alkali or oxygen, from the said substrate of the glass substrate type, a film which is a barrier to the migration of ions from the functional film to the substrate of the glass substrate type intended for the manufacture of plasma screen, nucleation film, or film with an optical role.

9. Substrate according to Claim 7, **characterised in that** the said thin film is on top of the functional film, in particular as a film protecting the functional film vis-à-vis high-temperature oxidation or chemical corrosion, a mechanical protection film of the non-scratch type, a film with an optical role, or a film improving the adhesion of the top film.

10. Substrate according to one of Claims 7 to 9, **characterised in that** the functional film is made from tin oxide doped with fluorine $SnO_2$:F, indium oxide doped with tin ITO, zinc oxide doped with indium ZnO:In, fluorine ZnO:F, aluminium ZnO:Al or tin ZnO:Sn, mixed oxide $Cd_2 SnO_4$ or titanium nitride or oxynitride TiN or zirconium nitride ZrN.

11. Substrate according to one of Claims 1 to 6, **characterised in that** the said thin film (2) is the only film covering the substrate or is associated with an anti-iridescence film and fulfils a non-scratch function.

12. Substrate according to Claim 11, **characterised in that** the said thin film (2) has a geometric thickness of at least 250 nanometres.

13. Substrate according to one of Claims 1 to 10, **characterised in that** the said thin film forms part of a stack of the glass/TiN and/or ZrN/thin film (2)/SiOC and/or $SiO_2$ type and in particular fulfils a function of solid interface between TiN and/or ZrN and SiOC and/or $SiO_2$ and an antioxidising function after the deposition of the top film of SiOC and/or $SiO_2$ on and/or off an industrial line.

14. Substrate according to Claim 13, **characterised in that** the said film of TiN has a geometric thickness of between 10 and 50 nanometres, the said thin film (2) has a geometric thickness of between 5 and 20 nanometres and the said top film of SiOC and/or $SiO_2$ has a geometric thickness of between 30 and 100 nanometres and **in that** the said stack has a selectivity of at least 7%.

15. Method of depositing the thin film (2) according to one of the preceding claims, performed by a technique of gaseous pyrolysis using at least two precursors, including at least one silicon precursor and at least one nitrogen precursor, **characterised in that** at least one nitrogen precursor is in the form of an amine, and **in that** the deposition temperature is chosen between 550o and 760oC, advantageously between 660oC and 760oC.

16. Method according to Claim 15, **characterised in that** the silicon precursor is a silane of the silazane or silicon hydride and/or alkyl type.

17. Method according to Claim 15 or 16, **characterised in that** the amine is a primary, secondary or tertiary amine, in particular with alkyl radicals each having 1 to 6 carbon atoms.

18. Method according to Claim 17, **characterised in that** the amine is ethyl amine $C_2H_5NH_2$, methylamine $CH_3NH_2$, dimethylamine $(CH_3)_2NH$, butylamine $C_4H_9NH_2$ or propylamine $C_3H_7NH_2$.

19. Method according to one of Claims 15 to 18, **characterised in that** the ratio in number of moles of the quantity of nitrogen precursor or precursors to the quantity of silicon precursor or precursors is between 5 and 30, preferably 10.

20. Method according to one of Claims 15 to 19, **characterised in that** the precursor of the additive is independent of the silicon and nitrogen precursors, and is in particular a fluorinated gas of the $CF_4$ type when the additive is fluorine F and a phosphate-carrying organic gas of the $PO(OCH_3)_3$ type or a gas of the triethylphosphite, trimethylphosphite or trimethylborate type, $PCl_3$, $PF_5$, $PBr_3$ or $PCl_5$, when

the additive is phosphorus P or boron B.

21. Method according to one of Claims 15 to 20, **characterised in that** the deposition of the said thin film is performed, in an essentially inert or hydrogenated atmosphere, without oxygen, continuously on a float glass ribbon, in the float vessel and/or in a chamber for monitoring the inert or reducing atmosphere.

22. Application of the substrate according to one of Claims 1 to 12 or of the method according to one of Claims 15 to 21, to the manufacture of glazing panes provided with thin films, solar protection of the filtering or low emissive and/or non-scratch type and/or with a mirror or non-reflecting function and/or with an anti-soiling function, "front or rear" faces of emissive screens of the flat screen type such as plasma screens.

23. Application according to Claim 22 to the manufacture of glazing provided with thin layers which can be tempered/bent and/or have great durability.

24. Application according to Claim 23, to single-piece, laminated or multiple glazing in which the substrate or substrates are clear or self-coloured.

25. Application of the product according to one of Claims 1 to 11 or of the method according to one of Claims 15 to 21 to the internal and/or external surface treatment of receptacles of the glass bottle or flask type.

**Patentansprüche**

1. Transparentes Substrat (1) vom Typ eines Glassubstrats, das mit mindestens einer dünnen Schicht (2) auf der Basis von Siliciumnitrid oder Siliciumnitridoxid beschichtet ist, **dadurch gekennzeichnet, dass** die dünne Schicht (2) bei einer Temperatur von 550 bis 760°C und vorzugsweise zwischen 660 und 760°C aufgebracht worden ist und die Elemente Si, O, N und C in folgenden Atomprozenten enthält:

   - Si: 30 bis 60 % und insbesondere 40 bis 50 %,
   - N: 10 bis 56 % und insbesondere 20 bis 56 %,
   - O: 1 bis 40 % und insbesondere 5 bis 30 % und
   - C: 1 bis 40 % und insbesondere 5 bis 30 %.

2. Substrat nach Anspruch 1, **dadurch gekennzeichnet, dass** die dünne Schicht mindestens ein Additiv, insbesondere in Form von einem Halogen, vorzugsweise Fluor, F, und/oder in Form von Phosphor, P oder Bor, B, vorzugsweise mit einem Atomprozentanteil von 0,1 bis 5 %, umfasst.

3. Substrat nach einem der vorhergehenden Ansprüche, **dadurch gekennzeichnet, dass** die dünne Schicht homogen ist oder in ihrer Dicke einen Zusammensetzungsgradienten besitzt.

4. Substrat nach einem der vorhergehenden Ansprüche, **dadurch gekennzeichnet, dass** die dünne Schicht einen Lichtabsorptionsgrad $A_L$ von kleiner als 2 % bei einer geometrischen Dicke von 100 Nanometern aufweist.

5. Substrat nach einem der vorhergehenden Ansprüche, **dadurch gekennzeichnet, dass** die geometrische Dicke der dünnen Schicht 5 nm bis 5 µm und insbesondere zwischen 20 und 1 000 Nanometern beträgt.

6. Substrat nach einem der vorhergehenden Ansprüche, **dadurch gekennzeichnet, dass** der Brechungsindex der dünnen Schicht mehr als 1,6, insbesondere 1,8 bis 2,0, und vorzugsweise 1,85 beträgt.

7. Substrat nach einem der vorhergehenden Ansprüche, **dadurch gekennzeichnet, dass** die dünne Schicht Teil eines Aufbaus aus dünnen Schichten ist, wovon mindestens eine eine funktionelle Schicht mit thermischen, insbesondere die Sonneneinstrahlung filternden, oder mit niedrig emittierenden und/oder elektrischen und/oder optischen und/oder photokatalytischen Eigenschaften wie eine Schicht mit Spiegelfunktion, vom Typ dotiertes Metalloxid, Metallnitrid/Metallnitridoxid, Metall vom Typ Aluminium bzw. Silicium oder Teil eines Aufbaus aus Antireflexschichten ist.

8. Substrat nach Anspruch 7, **dadurch gekennzeichnet, dass** die dünne Schicht sich unter der funktionellen Schicht, insbesondere als Barriereschicht gegen die Diffusion von Ionen, speziell Alkaliionen, und Sauerstoff aus dem Substrat vom Typ Glassubstrat, als Barriereschicht gegen die Migration der Ionen aus der funktionellen Schicht in das Substrat vom Typ Glassubstrat, das für die Herstellung von Plasmabildschirmen vorgesehen ist, als Kristallisationsschicht und als Schicht mit einer optischen Funktion befindet.

9. Substrat nach Anspruch 7, **dadurch gekennzeichnet, dass** sich die dünne Schicht auf der funktionellen Schicht, insbesondere als Schutzschicht der funktionellen Schicht vor Hochtemperaturoxidation oder chemischer Korrosion, als mechanische Schutzschicht vom Typ einer kratzfesten Schicht, als Schicht mit optischer Funktion und als Schicht, welche die Haftung der darüber liegenden Schicht verbessert, befindet.

**10.** Substrat nach einem der Ansprüche 7 bis 9, **dadurch gekennzeichnet, dass** die funktionelle Schicht aus mit Fluor dotiertem Zinnoxid, $SnO_2$:F, mit Zinn dotiertem Indiumoxid, ITO, mit Indium, ZnO:In, Fluor, ZnO:F, Aluminium, ZnO:Al, bzw. Zinn, ZnO:Sn, dotiertem Zinkoxid, Mischoxid, $Cd_2SnO_4$, Titannitrid bzw. Titannitridoxid, TiN, oder Zirconiumnitrid, ZrN, besteht.

**11.** Substrat nach einem der Ansprüche 1 bis 6, **dadurch gekennzeichnet, dass** die dünne Schicht (2) die einzige Schicht, die das Substrat bedeckt, oder mit einer das Irisieren verhindernden Schicht verbunden ist und eine kratzfeste Funktion erfüllt.

**12.** Substrat nach Anspruch 11, **dadurch gekennzeichnet, dass** die geometrische Dicke der dünnen Schicht (2) mindestens 250 Nanometer beträgt.

**13.** Substrat nach einem der Ansprüche 1 bis 10, **dadurch gekennzeichnet, dass** die dünne Schicht Teil eines Aufbaus vom Typ Glas/TiN und/oder ZrN/ dünne Schicht (2)/SiOC und/oder $SiO_2$ ist und insbesondere die Funktion einer festen Grenzfläche zwischen TiN und/oder ZrN und SiOC und/oder $SiO_2$ und eine die Oxidation verhindernde Funktion nach dem Aufbringen der Deckschicht aus SiOC und/oder $SiO_2$ in und/oder außerhalb der Produktionslinie erfüllt.

**14.** Substrat nach Anspruch 13, **dadurch gekennzeichnet, dass** die geometrische Dicke der TiN-Schicht 10 bis 50 Nanometer, die geometrische Dicke der dünnen Schicht (2) 5 bis 20 Nanometer und die geometrische Dicke der Deckschicht aus SiOC und/oder $SiO_2$ 30 bis 100 Nanometer beträgt, **und dass** der Aufbau eine Selektivitätskennzahl von mindestens 7 % besitzt.

**15.** Verfahren zum Aufbringen der dünnen Schicht (2) nach einem der vorhergehenden Ansprüche, das durch Gasphasenpyrolyse ausgehend von mindestens zwei Vorläufern, davon mindestens ein Siliciumvorläufer und mindestens ein Stickstoffvorläufer, durchgeführt wird, **dadurch gekennzeichnet, dass** mindestens ein Stickstoffvorläufer in Form eines Amins vorliegt, **und dass** die Abscheidetemperatur zwischen 550 und 760 °C und vorteilhafterweise zwischen 660 und 760 °C ausgewählt wird.

**16.** Verfahren nach Anspruch 15, **dadurch gekennzeichnet, dass** der Siliciumvorläufer ein Silan vom Typ Siliciumhydrid und/oder Alkylsilicium und Silazan ist.

**17.** Verfahren nach Anspruch 15 oder 16, **dadurch gekennzeichnet, dass** das Amin ein primäres, sekundäres oder tertiäres Amin und insbesondere mit Alkylresten mit jeweils 1 bis 6 Kohlenstoffatomen ist.

**18.** Verfahren nach Anspruch 17, **dadurch gekennzeichnet, dass** das Amin Ethylamin, $C_2H_5NH_2$, Methylamin, $CH_3NH_2$, Dimethylamin, $(CH_3)_2NH$, Butylamin, $C_4H_9NH_2$, und Propylamin, $C_3H_7NH_2$, ist.

**19.** Verfahren nach einem der Ansprüche 15 bis 18, **dadurch gekennzeichnet, dass** das Verhältnis von Anzahl der Mole der Menge an Stickstoffvorläufer (n) zur Menge an Siliciumvorläufer(n) 5 bis 30 und vorzugsweise 10 beträgt.

**20.** Verfahren nach einem der Ansprüche 15 bis 19, **dadurch gekennzeichnet, dass** der Vorläufer des Additivs unabhängig von den Silicium- und Stickstoffvorläufern und insbesondere ein fluorhaltiges Gas vom Typ $CF_4$ ist, wenn das Additiv Fluor, F, ist, und ein Phosphat tragendes organisches Gas vom Typ $PO(OCH_3)_3$ oder ein Gas vom Typ Triethylphosphit, Trimethylphosphit, Trimethylborit, $PCl_3$, $PF_5$, $PBr_3$ und $PCl_5$ ist, wenn das Additiv Phosphor, P, oder Bor, B, ist.

**21.** Verfahren nach einem der Ansprüche 15 bis 20, **dadurch gekennzeichnet, dass** das Abscheiden der dünnen Schicht in einer sauerstofffreien im Wesentlichen inerten oder wasserstoffhaltigen Atmosphäre kontinuierlich auf einem Floatglasband in der Floatglaswanne und/oder in einem Behälter mit kontrollierter inerter oder reduzierender Atmosphäre durchgeführt wird.

**22.** Verwendung des Substrats nach einem der Ansprüche 1 bis 12 oder Anwendung des Verfahrens nach einem der Ansprüche 15 bis 21 zur Herstellung von Gläsern, die mit dünnen Schichten versehen sind, die vom Typ eines Filters vor Sonneneinstrahlung schützend oder niedrig emittierend und/oder kratzfest und/oder spiegelnd oder antireflektierend und/ oder schmutzabweisend sind, als "Vorder- oder Rückseite" von selbstleuchtenden Bildschirmen vom Typ Flachbildschirmen wie Plasmabildschirmen.

**23.** Verwendung/Anwendung nach Anspruch 22 zur Herstellung von vorspannbaren/biegbaren und/ oder sehr beständigen Gläsern, die mit dünnen Schichten versehen sind.

**24.** Verwendung/Anwendung nach Anspruch 23 für monolithische, Verbund- und Mehrfachverglasungen, in welchen das (die) Substrat(e) klar oder in der Masse gefärbt ist (sind).

**25.** Verwendung des Erzeugnisses nach einem der Ansprüche 1 bis 11 oder Anwendung des Verfahrens nach einem der Ansprüche 15 bis 21 für die Behandlung der Innen - und/oder Außenfläche von Gefäßen vom Typ Glasflaschen und/oder -fläschchen.

**Fig. 1**

Fig. 2